# EUROPÄISCHE PATENTSCHRIFT

(11) **EP 0 219 855 B1**
(45) Veröffentlichungstag und Bekanntmachung des Hinweises auf die Patenterteilung: **24.02.1993**
(21) Anmeldenummer: 86114592.8
(22) Anmeldetag: 21.10.1986
(51) Int. Cl.: G01V 3/10, H03F 3/68

(54) **Verfahren zum Suchen und Orten Inhomogenitäten und Schaltungsanordnung zum Durchführen dieses Verfahrens**
Method for searching and sounding inhomogeneities, and circuitry for carrying out this method
Procédé pour chercher et relever des inhomogénéités et circuit pour la mise en oeuvre de ce procédé

(30) Priorität: 24.10.1985 DE 3538228
(43) Veröffentlichungstag der Anmeldung: 29.04.1987
(73) Patentinhaber: Ebinger, Klaus, D-51149 Köln (DE)
(72) Erfinder: Ebinger, Klaus, D-5000 Köln 90 (DE); Günnewig, Augustinus, D-5000 Köln 60 (DE)
(74) Vertreter: Berkenfeld, Helmut, Dipl.-Ing.

(56) Entgegenhaltungen:
- DE-C- 2 549 329
- FR-A- 1 469 499
- FR-A- 2 361 672
- GB-A- 1 561 641
- US-A- 4 472 688

## Beschreibung

Die Erfindung betrifft ein Verfahren zum Suchen und Orten von Inhomogenitäten in einer nichtmetallischen Umgebung, mit einem Gerät mit einem Sensorsystem zum Erzeugen eines Signals, bestehend im wesentlichen aus einer Suchspule, einem Oszillator und einem Gleichrichter, mit einem an das Sensorsystem angeschlossenen Verstärkungskanal und mit einer an diesen angeschlossenen akustischen und/oder optischen Signalanzeige. Die Erfindung betrifft weiter eine Schaltungsanordnung zum Durchführen dieses Verfahrens.

Nach diesem Prinzip arbeitende Such- und Ortungsgeräte sind bekannt. Man unterscheidet solche mit dynamischer und statischer Betriebsart. Dynamisch bedeutet, daß die Suchspule am Suchort hin- und herbewegt wird. Bei Vorliegen einer Inhomogenität entsteht ein akustisch oder optisch anzuzeigendes Signal. Ein Vorteil der dynamischen Betriebsart liegt darin, daß sich das Gerät automatisch auf die schwankenden elektrischen Verhältnisse am Suchort einpegelt. Schwankende elektrische Eigenschaften des Erdbodens werden bei der dynamischen Betriebsart in gewissen Grenzen ausgeschaltet und gehen nicht in das Signal ein. Ein Nachteil der dynamischen Betriebsart kann sich jedoch daraus ergeben, daß sie eine ständige Relativbewegung zwischen der Suchspule und dem Suchobjekt erfordert. Anderenfalls geht das Signal nach einer vorgegebenen Zeit auf seinen eingestellten Normalpegel zurück und wird nicht mehr als Anzeigesignal erkannt. Die ständig erforderliche Hin- und Herbewegung der Suchspule kann auch auf Schwierigkeiten stoßen. So ist eine solche Hin- und Herbewegung zum Beispiel beim Orten eines Metallgegenstandes in einem tiefen Loch unmöglich. Zu erwähnen ist weiter, daß die Suchspule bei einem Suchen im Liegen nur ganz geringfügig hin- und herbewegt werden kann. Auch ist das genaue Lokalisieren in unmittelbarer Nähe des Suchobjektes sehr schwierig, da sich das Signal mit einer gewissen zeitlichen Verzögerung immer wieder auf seinen Normalwert einpegelt.

Unter dem Namen Waffendetektor ist ein Suchgerät (DE-C-2 549 329) bekannt, das nach dem Verfahren der eingangs genannten Gattung arbeitet. Dieser Waffendetektor arbeitet ausschließlich dynamisch. Als sogenannte Handsonde wird er zum Beispiel an Flughäfen verwandt um festzustellen, ob Fluggäste an ihrem Körper Metall tragen. Die Schaltung dieses Waffendetektors enthält unter anderem einen als Phasenschieber oder Tonumsetzer arbeitenden Transistor. Der Arbeitspunkt dieses Transistors wird über einen Spannungsteiler über seine Basisschwellspannung hinaus ins Negative verschoben. Weiter ist eine Gegenkopplung mit einem RC-Glied vorgesehen. Dessen Kapazität liegt an Masse. Die Gegenspannung wird dem Kollektor des Transistors zugeleitet. Sie wirkt wie eine Kompensationsspannung und hat zur Folge, daß die Tonschwingungen sehr weich einsetzen. Eine weitere Gegenkopplung erfolgt zwischen dem Tonfrequenzausgang und der Basis des eben genannten Transistors. Mit dieser Gegenkopplung werden langsame elektrische Änderungen ausgeglichen. Wie bereits ausgeführt wurde, arbeitet dieser bekannte Waffendetektor ausschließlich dynamisch. Weiter sind die Gegenkopplungen starr vorgegeben. Der Anwender kann die Stärke der Gegenkopplung nicht beeinflussen.

Bei der statischen Betriebsart hängt die Stärke des Signals ausschließlich von der Größe der Suchspule ab. Auch ohne Relativbewegung entsteht ein Signal. Verharrt die Suchspule über dem Suchobjekt, entsteht ein konstantes Signal. Dies kann entsprechend der Anzeigegeometrie zu- oder abnehmen. Die statische Betriebsart weist jedoch einen wesentlichen Nachteil auf. Dieser liegt darin, daß sämtliche elektrischen Schwankungen innerhalb des Gerätes, Nullpunktwanderungen und dergleichen, eine inhomogene Beschaffenheit des Bodens oder Mineralisierungen ein Signal auslösen. Auch bei homogener Beschaffenheit des Bodens löst jede Veränderung des Abstandes zwischen der Suchspule und dem Boden ein Signal aus, das bei dynamischem Suchbetrieb innerhalb gewisser Grenzen selbsttätig ausgeblendet werden würde.

Zum Verringern dieser Schwierigkeiten sind Such- und Ortungsgeräte entwickelt worden, bei denen die Betriebsart und die Empfindlichkeit stufenweise oder auch stufenlos so geändert werden können, daß der Dynamikbereich der akustischen und/ oder optischen Signalanzeige nicht überschritten wird. Die Umschaltung muß jedoch von Hand erfolgen. Häufig müssen auch die Empfindlichkeit und der Arbeitspunkt der Signalanzeige eingestellt und an die Suchaufgabe angepaßt werden. Bei den bekannten Such- und Ortungsgeräten können noch weitere Nachteile auftreten. In unmittelbarer Nähe des Suchobjektes kann das Sensorsystem durch die Nähe zu einem zum Beispiel metallischen Suchobjekt gesättigt oder überfahren werden. Der Oszillator kann aussetzen. Der Dynamikbereich der Signalanzeige wird früh übersteuert. Das Signal bleibt konstant. In der Suchpraxis führt dies zu erheblichen Nachteilen. Es ergibt sich eine sehr schlechte Auflösung. Zwischen benachbarten Metallgegenständen kann nicht unterschieden werden. Einzelne Metallgegenstände lassen sich nicht herausfinden. Zwischen großen und kleinen Metallgegenständen läßt sich nicht unterscheiden. Dies ist jedoch erforderlich, wenn im Boden unter gegenseitigem Abstand versteckte Minen nachträglich mit Stahlnadeln überdeckt werden.

Bekannt ist eine Schaltungsanordnung, die vorwiegend, aber nicht ausschließlich zur Detektion der Anwesenheit, der Durchfahrt und der Zählung von Kraftfahrzeugen an einem vorgegebenen Ort dient (FR-A-1 469 499). Diese bekannte Schaltungsanordnung beruht auf der Erkenntnis, daß sich die Induktivität einer an eine Wechselspannung mit hoher Frequenz angeschlossenen Leiterschleife bei Eintauchen eines metallischen Gegenstandes in das von ihr erzeugte Magnetfeld ändert. Diese bekannte Schaltungsanordnung enthält eine Brücke. In einem Brückenzweig liegt ein Bezugs- und in einem anderen Brückenzweig liegt eine Detektorspule. Angeschlossen an die Brücke ist ein dynamischer Impulsverstärker mit einem nachgeschalteten Schwellwertverstärker. Im Verstärkungszug liegt unter anderem ein Transistor, dessen Basis mit einer im einzelnen nicht beschriebenen Einrichtung, offensichtlich von Hand, entweder an einem Widerstand oder an einen Kondensator gelegt wird. Bei Verbindung mit dem Widerstand arbeitet die Schaltungsanordnung als Anwesenheitsdetektor. Bei Verbindung mit dem Kondensator arbeitet sie als Durchfahrtdetektor. Bekannt ist eine weitere als Anwesenheitsdetektor für Kraftfahrzeuge arbeitende Schaltungsanordnung (GB-A-1 561 641). Diese Schaltungsanordnung enthält unter anderem einen Verstärker mit einer nachgeschalteten Vergleichsstufe. Die letztere beaufschlagt einen sogenannten Analysator. Vom Ausgang der Vergleichsstufe führt eine Gegenkopplung zum Eingang des Verstärkers zurück. Im Weg der Gegenkopplung liegt ein ein RC-Glied enthaltendes Tiefpaßfilter. Bekannt ist weiter eine steuerbare Verstärkerschaltung (US-A-4 472 688). Am Eingang dieser Verstärkerschaltung liegt ein an eine Bezugsspannung angeschlossener Komparator. Bei hohen Eingangssignalen schaltet er den Eingang auf einen Verstärker für hohe und bei niedrigen Eingangsspannungen schaltet er diesen auf einen Verstärker für niedrige Eingangsspannungen durch. Die Schaltung enthält weiter noch eine Mitkopplung und ein Zeitglied. Diese sorgen dafür, daß der Verstärker für hohe Spannungen bei einem kurzzeitigen Abfall der Eingangsspannung nicht sofort aus- und der Verstärker für die niedrige Eingangsspannung sofort eingeschaltet wird.

Von diesem Stand der Technik ausgehend stellt sich die Aufgabe, ein Verfahren auszubilden, das die Vorteile eines dynamischen und eines statischen Suchbetriebes bei der Detektion von Inhomogenitäten in einer nichtmetallischen Umgebung in sich vereint. Die Lösung für diese Aufgabe ergibt sich bei einem Verfahren der eingangs genannten Gattung nach der Erfindung dadurch, daß ein dynamisch arbeitender Verstärkungskanal zwischen Sensorsystem und Signalanzeige eingeschaltet ist und ein statisch arbeitender Verstärkungskanal bei Überschreiten des Dynamikbereiches des ersteren selbsttätig eingeschaltet und dieser dann ausgeschaltet wird. Das Umschalten erfolgt somit selbsttätig. Unterschiedlich zum Stand der Technik muß die Bedienung nicht von Band von dar einen in die andere Betriebsart umschalten und dabei den Suchbetrieb unterbrechen. Die Bedienung tastet sich mit Hin- und Herbewegungen der Suchspule an das Suchobjekt heran. Bei zunehmender Annäherung an dieses wird automatisch auf den statischen Suchbetrieb umgeschaltet. Die Hin- und Herbewegungen der Suchspule werden kleiner und entfallen schließlich bei maximaler Annäherung an das Suchobjekt.

Die erfindungsgemäße Schaltungsanordnung zum Durchführen dieses Verfahrens enthält in bekannter Weise ein Sensor- oder Signalgebersystem aus einer Suchspule, einem Oszillator und einem Gleichrichter. An dieses System ist ein Verstärkungskanal und an diesen ist eine akustische und/oder optische Signalanzeige angeschlossen. Die erfindungsgemäße Schaltungsanordnung zeichnet sich dadurch aus, daß ein dynamisch und ein statisch arbeitender Verstärkungskanal vorgesehen sind und beide zwischen Sensorsystem und Signalanzeige liegen und der letztere bei Überschreiten des Dynamikbereiches des ersteren selbsttätig eingeschaltet und dieser dann ausgeschaltet wird. Die Umschaltung erfolgt somit erfindungsgemäß selbsttätig. Hierzu liegt ein elektronischer Speicher mit einstellbarer Zeitkonstante am Eingang des statisch arbeitenden Verstärkungskanals. Der elektronische Speicher kann ein digitales System sein. In einer anderen Ausführungsform liegt am Eingang des statisch arbeitenden Verstärkungskanals ein RC-Glied mit einstellbarem Widerstand. Erfindungsgemäß liegt diesem ein Taster bzw. Ein- und Ausschalter parallel.

Zum Abgleich der beiden Verstärkungskanäle und zur Anpassung des Gerätes an die Suchaufgabe ist in einer weiteren Ausgestaltung vorgesehen, daß die in den Verstärkungskanälen liegenden Verstärker mit je einem Eingang verschiedener Polarität im Verstärkungsweg liegen und diese über einen einstellbaren Widerstand an eine Bezugsspannung angeschlossen sind. Dabei sollte der einstellbare Widerstand ein Potentiometer sein, dessen eines Ende an Masse und dessen anderes Ende an der Bezugsspannung liegt und dessen Schleifer mit den Eingängen der beiden Verstärker verbunden ist. Dabei sollte der Eingang des statischen Verstärkers über einen einstellbaren Widerstand an das Potentiometer bzw. den entsprechenden Eingang des dynamischen Verstärkers angeschlossen sein.

Der am Eingang des statischen Verstärkungskanals liegende Speicher oder das dort liegende RC-Glied bewirkt in einer noch zu beschreibenden Weise, daß der statische Verstärkungskanal bei bestimmten Bedingungen eingeschaltet wird. Damit die Signalanzeige dann nicht von beiden Verstärkungskanälen beaufschlagt wird, ist in einer weiteren Ausgestaltung vorgesehen, daß zwischen dem Ausgang des dynamischen Verstärkungskanals und der Signalanzeige ein elektronischer Schalter liegt und dieser mit seinem Steuereingang an den Ausgang des statischen Verstärkungskanals derart angeschlossen ist, daß er die Signalanzeige bei Erreichen eines vorgegebenen Spannungspegels am Ausgang des statischen Verstärkungskanals vom dynamischen Verstärkungskanal trennt. Zweckmäßig beaufschlagen die beiden Verstärkungskanäle die Signalanzeige mit einer unterschiedlichen Frequenz, zum Beispiel unterschiedlicher Tonhöhe. Dann läßt sich das Umschalten von dem einen zu dem anderen Verstärkungskanal sofort akustisch erkennen.

Zum Lösen der eingangs genannen Aufgabe sieht die Erfindung noch eine weitere Schaltungsanordnung vor. Diese enthält nur einen einzigen Verstärkungskanal. Sie zeichnet sich dadurch aus, daß der Verstärker des Verstärkungskanals über ein RC-Glied derart gegengekoppelt ist, daß im Gegenkopplungsweg höherfrequente, schnelle Änderungen des Signals nach Masse abgeleitet werden und damit nur diese, da sie nicht auf den Verstärker gegengekoppelt werden, den Verstärkungskanal ungeschwächt durchlaufen und daß ein einstellbarer Begrenzer zwischen dem RC-Glied und dem Eingang des Verstärkers liegt. Langsame Änderungen, wie sie zum Beispiel durch elektrisches Driften im Gerät selbst oder auch durch störende Bodenformationen hervorgerufen werden, werden, da sie den Gegenkopplungsweg ohne Ableitung nach Masse durchlaufen und damit als Gegenkopplungsspannung zum Eingang des Verstärkers zurückgeführt werden, unterdrückt. Damit stellt sich das Gerät selbsttätig auf die jeweiligen elektrischen Ortungsverhältnisse ein. Es ergeben sich die Vorteile eines dynamischen Suchbetriebs. Mit dem einstellbaren Begrenzer läßt sich die Stärke der Gegenkopplung beeinflussen. Zweckmäßig enthält der Gegenkopplungsweg einen an den Verstärker angeschlossenen Gleichrichter, und das RC-Glied ist an diesen angeschlossen, wobei der Kondensator mit einem Pol an Masse liegt und das RC-Glied zum Eingang des Verstärkers zurückgeführt ist. Dem Verstärker ist ein Tonumsetzer vorgeschaltet, und das RC-Glied ist auf diesen zurückgeführt. Der Widerstand des RC-Gliedes ist vorzugsweise einstellbar.

Dem erfindungsgemäßen Verfahren, der eingangs genannten erfindungsgemäßen und der vorstehend genannten weiteren Schaltungsanordnung liegt der gemeinsame Gedanke zugrunde, daß sie selbsttätig und ohne Zutun der Bedienung von der einen auf die andere Betriebsart umschaltet. Bei der ersten Schaltungsanordnung liegt am Eingang des statisch arbeitenden Verstärkungskanals ein zum Beispiel aus einem RC-Glied bestehender elektronischer Speicher, während bei der zweiten Schaltungsanordnung der Verstärker über ein RC-Glied in bestimmter Weise gegengekoppelt ist. Das Verfahren und beide Schaltungsanordnungen dienen nicht zur Detektion der Anwesenheit oder Durchfahrt von Kraftfahrzeugen.

Am Beispiel der in der Zeichnung gezeigten Schaltungsanordnungen und Schaubilder wird die Erfindung nun weiter beschrieben. In der Zeichnung ist:
- Fig. 1: ein Blockschaltbild der ersten erfindungsgemäßen Ausführungsform der Schaltungsanordnung mit einem dynamischen und einem statischen Verstärkungskanal,
- Fig. 2: ein Blockschaltbild der weiteren Ausführungsform mit nur einem Verstärkungskanal und einer besonderen Rückkopplung,
- Fig. 3: ein Schaubild mit Darstellung des Anzeigeverlaufs bei einem Suchgerät nach dem Stand der Technik,
- Fig. 4: ein Schaubild mit Darstellung des Anzeigeverlaufs bei der Schaltungsanordnung nach Fig. 1,

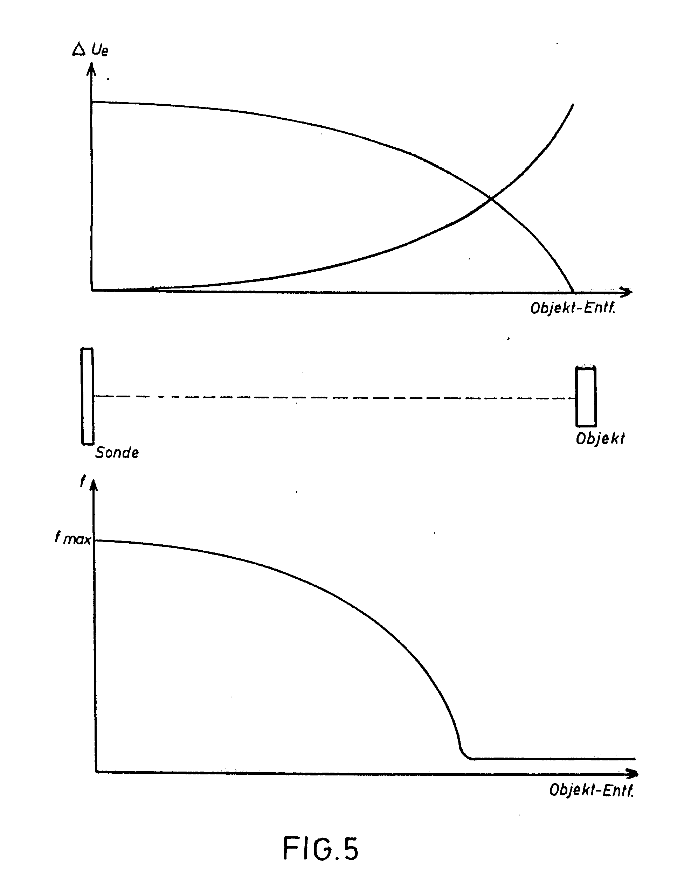

- Fig. 5: ein Schaubild mit Darstellung des Anzeigeverlaufs wieder bei einem Suchgerät nach dem Stand der Technik und

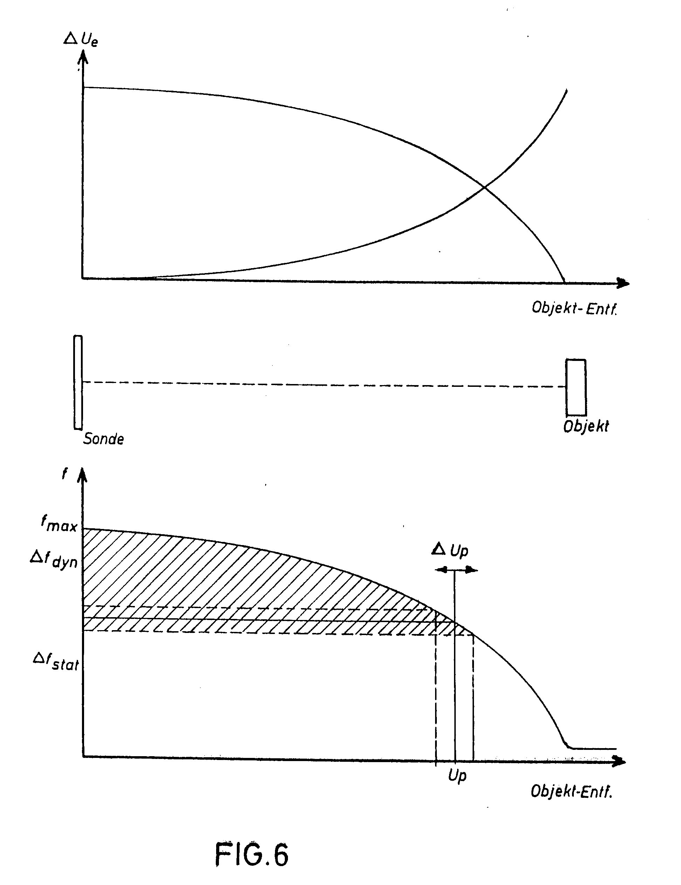

- Fig. 6: ein Schaubild mit Darstellung des Anzeigeverlaufs bei einer erfindungsgemäßen Schaltungsanordnung.

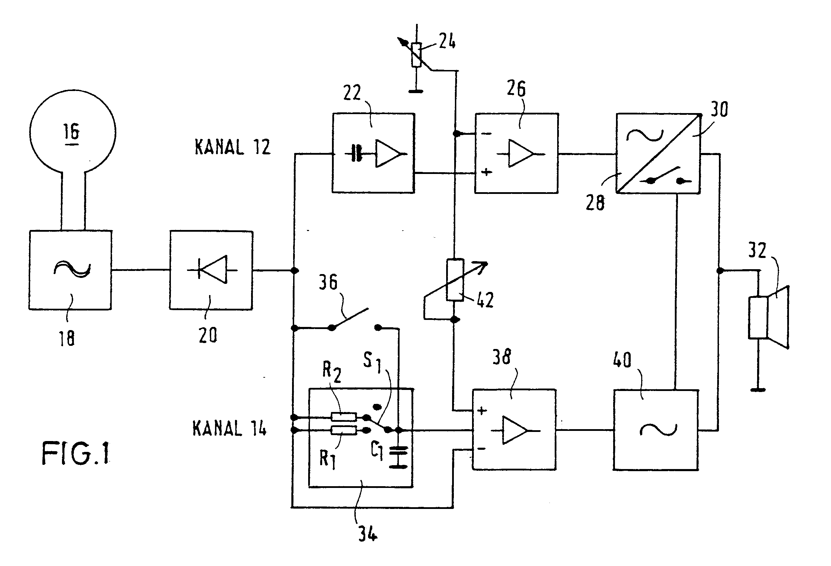

Die in Fig. 1 gezeigte Schaltungsanordnung enthält einen dynamisch arbeitenden Verstärkungskanal 12 und einen statisch arbeitenden Verstärkungskanal 14. Beiden ist das Sensor- oder Gebersystem vorgeschaltet. Dieses besteht aus der Suchspule 16, dem Oszillator 18 und dem Gleichrichter 20. Im dynamisch arbeitenden Kanal 12 liegt der dynamische Verstärker 22. Die Reihenkapazität deutet an, daß dieser höherfrequente Schwingungen oder schnelle Änderungen bevorzugt verstärkt. Ein Potentiometer 24 liegt als Spannungsteiler zwischen einer Bezugsspannungsquelle und Masse. Ein Differenzverstärker 26 liegt mit einem Eingang am dynamischen Verstärker 22 und mit seinem anderen Eingang am Schleifer des Potentiometers 24. Ein Tonumsetzer 28 und ein elektronischer Schalter 30 sind dem Differenzverstärker 26 nachgeschaltet. Ein Signalgeber 32, zum Beispiel ein Lautsprecher, ist an den Tonumsetzer 28 bzw. den Schalter 30 angeschlossen. Am Eingang des statisch arbeitenden Kanales 14 liegt ein elektronischer Speicher 34. Im gezeigten Beispiel besteht dieser im wesentlichen aus einem Kondensator C₁, zwei Widerständen R₁ und R₂ und einem Umschalter S₁. Der Umschalter S₁ Weist drei Kontakte auf. Man muß sich vorstellen, daß am dritten Kontakt ein unendlich großer Widerstand liegt. Ein Taster oder ein Ein/Ausschalter 36 liegt über dem Umschalter S₁ und den Widerständen. Ein Differenzverstärker 38 ist dem Speicher 34 nachgeschaltet. Ihm folgt ein Tonumsetzer 40. Dieser führt zum Signalgeber 32. Gleichzeitig ist er an den Steuereingang des elektronischen Schalters 30 angeschlossen. Mit seinem positiven Eingang ist der Differenzverstärker 38 über einen einstellbaren Widerstand 42 noch an die Bezugsspannungsquelle bzw. das Potentiometer 24 angeschlossen. Wichtig ist, daß die beiden Differenzverstärker 26 und 38 mit Eingängen verschiedener Polarität am Schleifer des Potentiometers 24 liegen.

Der dynamisch arbeitende Verstärkungskanal 12 verfügt über eine hohe Empfindlichkeit. Damit werden hohe Ortungsweiten erzielt. Schon bei großer Entfernung zum Suchobjekt entsteht ein Signal. Innerhalb gewisser Grenzen läßt sich die Empfindlichkeit mit dem Potentiometer 24 einstellen. Dieses verändert die Tonansprechschwelle. Bei großer Annäherung an das Suchobjekt ist die Empfindlichkeit des dynamisch arbeitenden Kanales 12 zu hoch. Ein Suchobjekt läßt sich nur schwierig genau lokalisieren. Hier wird der statisch arbeitende Kanal 14 wirksam. Dieser wird selbsttätig eingeschaltet.

Auch der Arbeitspunkt des statisch arbeitenden Kanales 14 läßt sich mit dem Potentiometer 24 beeinflussen. Wie ausgeführt, sind die Verstärker 26 und 38 mit Eingängen verschiedener Polarität an das Potentiometer 24 angeschlossen. In der Praxis bedeutet dies, daß bei Drehen des Potentiometers 24 in der einen Richtung die Tonschwelle des einen und bei Drehen des Potentiometers 24 in der anderen Richtung die Tonschwelle des anderen Kanales justiert wird. Damit läßt sich auch der Umschaltpunkt von einem zum anderen Kanal beeinflussen. Mit dem Potentiometer 42 kann dabei eine Überlappung erreicht werden.

Der statisch arbeitende Kanal 14 kommt wie folgt zum Einsatz:
Die am Ausgang des Gleichrichters 20 anstehende Gleichspannung steht auch am Eingang des Speichers 34 an. Dieser hat eine einstellbare Zeitkonstante. Dabei hat man sich unter R₁ einen kleinen und unter R₂ einen größeren Widerstand vorzustellen. Mit dem Umschalter S₁ läßt sich nun ein statisches oder ein sogenanntes quasi statisches Suchverhalten einstellen. Der Speicher 34 läßt sich als digitaler oder analoger Speicher ausbilden. Kostengünstig ist ein weitgehend driftfreier Analogspeicher in der Art eines hochohmigen Operationsverstärkers, der gleichzeitig als Impedanzwandler geschaltet ist. Durch die hohe Eingangsimpedanz und bei guter Isolation der Kapazität C₁ ergibt sich eine hohe Speicherzeit. Der Speicher 34 bewirkt eine einstellbare Verzögerung des vom Gleichrichter 20 abgegebenen Gleichspannungssignales. DAs so Verzögerte Signal gelangt zu dem positiven Eingang des Differenzverstärkers 38, während dessen anderer Eingang das Signal ohne Verzögerung erhält. Die so erzeugte Spannungsdifferenz wird im Differenzverstärker 38 verstärkt und gelangt zum Tonumsetzer 40. Dieser beaufschlagt den Signalgeber 32. Bei ausreichender Stärke des Tonsignales wird auch der Schalter 30 wirksam und trennt den Signalgeber 32 vom dynamischen Verstärkungskanal 12 ab. Sofern die Tonumsetzer 28 und 40 Signale verschiedener Frequenz erzeugen, läßt sich das Umschaltest akustisch sofort erkennen. Durch das Drucken des Tasters 36 wird die Ausgangsspannung des Gleichrichters 34 sofort auf die Kapazität C₁ gegeben und dort als Sollwert gespeichert. Dann erhalten die beiden Eingänge des Differenzverstärkers 38 die gleiche Spannung. Die Ausgangsspannung fällt sofort auf Null ab. Der Taster 36 wirkt auch als Kompensationstaster. Bei Drücken wird zum Beispiel die Einwirkung von konstanten Metallmassen ausgeschaltet. Das Gerät wird wieder empfindlich. Zusätzliche Störungen werden angezeigt. Durch Drehen des Schleifers des Potentiometers 24 bis zum einen oder anderen Anschlag kann die Empfindlichkeit des einen oder des anderen Kanales so weit abgesenkt werden, daß das Gerät nur noch dynamisch oder nur noch statisch arbeitet.

Es wurde ausgeführt, daß die Tonumsetzer 28 und 40 Signale verschiedener Frequenz abgeben. Der elektronische Schalter 30 kann weiter so eingestellt werden, daß beide Signale für einen bestimmten Bereich gleichzeitig zum Signalgeber 32 gelangen. Dadurch erfährt die Bedienung, daß das Suchobjekt nicht mehr weit entfernt sein kann und das Gerät bald vom Verstärkungskanal 12 auf den Kanal 14 umschaltet. Der Umschaltpunkt und der Überlappungsbereich lassen sich mit dem Widerstand 42 einstellen.

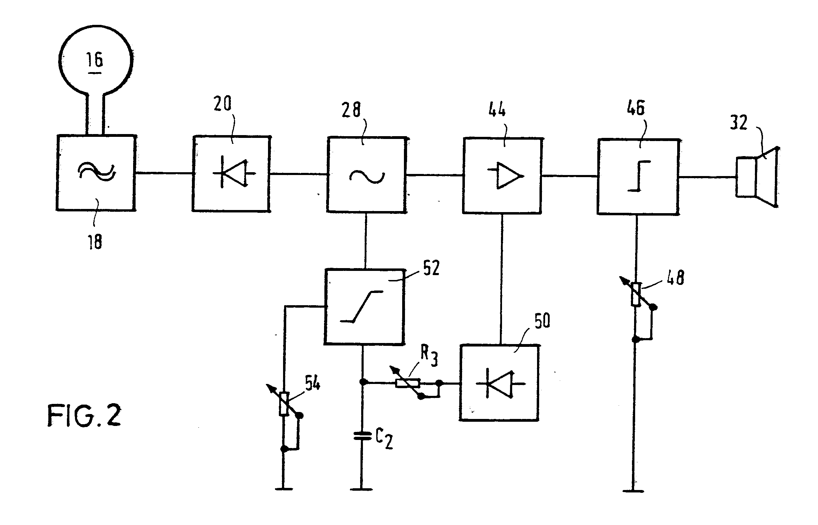

Die in Fig. 2 gezeigte Ausführungsform enthält wieder ein Geber- oder Sensorsystem mit einer Suchspule 16, einem Oszillator 18 und einem Gleichrichter 20. Diesem folgen ein Tonumsetzer 28, ein Tonfrequenzverstärker 44 und eine Triggerstufe 46. Deren Triggerschwelle wird mit einem Drehwiderstand 48 eingestellt. Am Ausgang der Triggerstufe 46 liegt ein Signalgeber 32 bzw. ein kleiner Lautsprecher oder ein Kopfhörer. Das Besondere dieser Schaltungsanordnung liegt in einer als Gegenkopplung ausgebildeten Rückkopplung. Im Rückkopplungskreis liegen ein Gleichrichter 50, ein RC-Glied aus einem einstellbaren Widerstand R₃ und einer Kapazität C₂ und ein Spannungsbegrenzer bzw. Regelbegrenzer 52. Dieser wird durch einen Drehwiderstand 54 eingestellt.

Die Empfindlichkeit dieser Schaltungsanordnung wird mit der Triggerstufe 46 und dem Drehwiderstand 48 eingestellt. Die Schaltungsanordnung arbeitet grundsätzlich dynamisch. Mit dem Drehwiderstand 54 läßt sich der Punkt einstellen, an dem die Schaltung vom dynamischen in den statischen Betrieb übergeht.

Die Schaltung arbeitet wie folgt:
Die im Tonumsetzer 28 erzeugte Tonfrequenz wird im Verstärker 44 verstärkt und zum Signalgeber 32 weitergeleitet. Weiter wird sie im Gleichrichter 50 gleichgerichtet. Diese Gleichspannung wird durch das RC-Glied einstellbar verzögert. Diese verzögerte Gleichspannung wird als Gegenkopplungsspannung so zum Tonumsetzer 28 zurückgeführt, daß die vom Gleichrichter 20 abgegebene Gleichspannung mit einer Zeitkonstante entsprechend dem des RC-Gliedes ausgeregelt wird. Diese Gegenkopplung bewirkt, daß nur höherfrequente Spannungen bzw. schnelle Änderungen zum Signalgeber 32 durchgegeben werden. Langsame Änderungen, wie sie zum Beispiel durch elektrisches Driften im Gerät selbst oder auch durch störende Bodenformationen hervorgerufen werden, werden unterdrückt. Damit stellt sich das Gerät selbsttätig auf die jeweiligen elektrischen Ortungsverhältnisse ein. Es ergeben sich die Vorteile eines dynamischen Suchbetriebs.

Mit dem Drehwiderstand 54 lassen sich der Arbeitspunkt des Regelbegrenzers 52 und damit die Stärke der Gegenkopplung einstellen. Damit wird der Punkt bestimmt, an dem die Gegenkopplung endet und das Gerät vom dynamischen zum statischen Betrieb umschaltet.

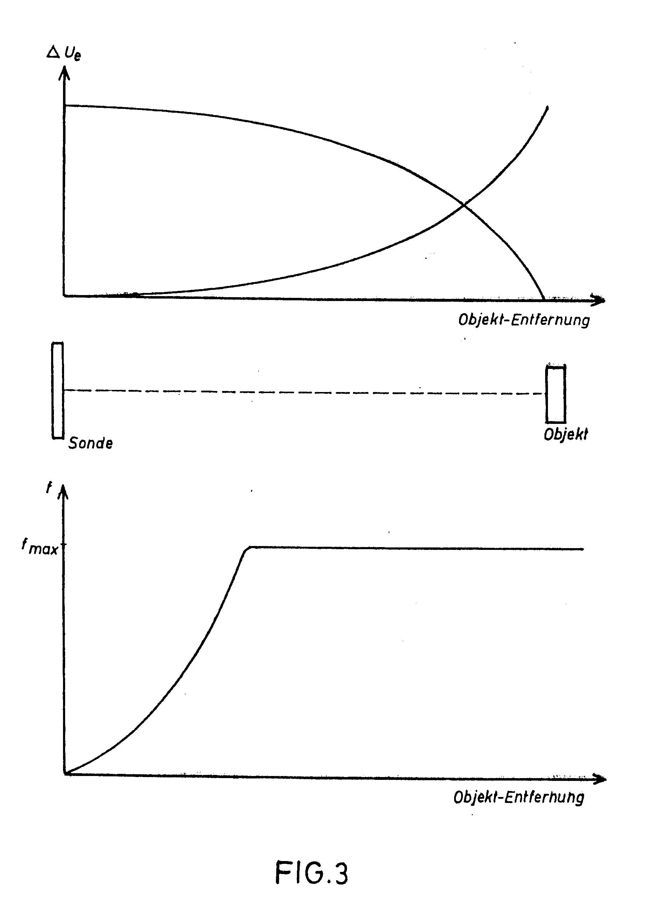

Fig. 3 zeigt den Anzeigeverlauf, wie er für ein Suchgerät nach dem Stand der Technik typisch ist. Ab einem bestimmten Abstand zum Suchobjekt wird dieses in seiner Anzeige voll ausgesteuert. Im oberen Teil von Fig. 3 wird eine mit der Entfernung zum Suchobjekt ansteigende und abfallende Steuerspannung gezeigt. Gemäß der Darstellung im unteren Teil von Fig. 3 wird diese Steuerspannung in eine Tonfrequenz umgesetzt. Bei Erreichen der maximalen Frequenz fmax muß die Empfindlichkeit manuell umgeschaltet werden. Hierbei spielt es keine Rolle, ob das Gerät statisch oder dynamisch arbeitet.

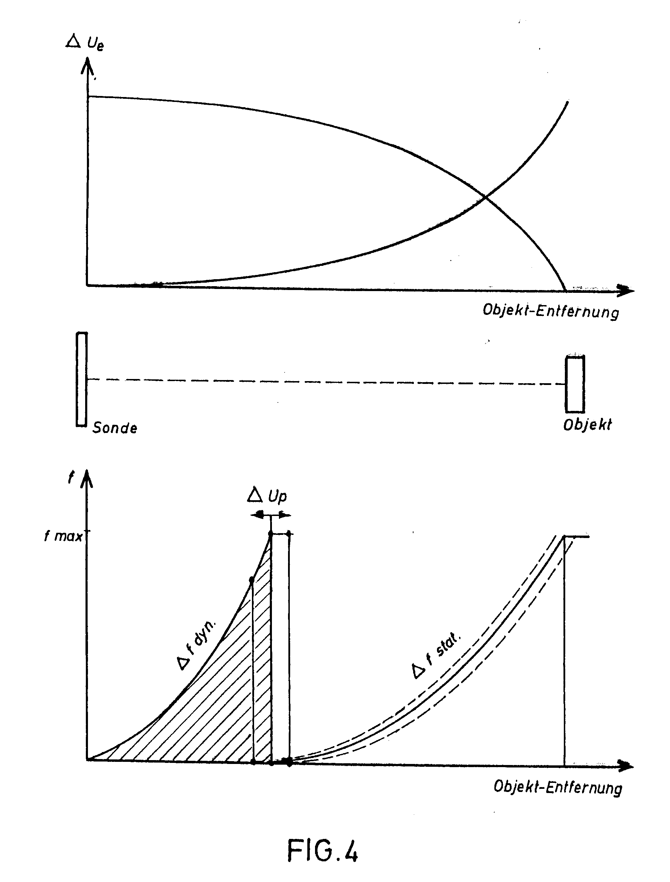

Fig. 4 beschreibt die Wirkungsweise der erfindungsgemäßen Schaltungsanordnung nach Fig. 1. In der oberen Hälfte von Fig. 4 wird wieder die Abhängigkeit der Steuerspannung von der Entfernung zum Suchobjekt dargestellt. In der unteren Hälfte von Fig. 4 wird gezeigt, wie das Gerät zuerst dynamisch und anschließend statisch arbeitet. Bei fmax wird automatisch umgeschaltet. Der Umschaltpunkt △ UP läßt sich verschieben. Das im Tonumsetzer 40 erzeugte Tonfrequenzsignal wird zugegeben, wenn der dynamische Anzeigebereich praktisch vollständig ausgesteuert ist. Eine gewisse Überlappung, die sich mit 42 einstellen läßt, ist vorhanden.

## Patentansprüche

1. Verfahren zum Suchen und Orten von Inhomogenitäten in einer nichtmetallischen Umgebung, mit einem Gerät mit einem Sensorsystem zum Erzeugen eines Signales, bestehend im wesentlichen aus einer Suchspule, einem Oszillator und einem Gleichrichter, mit Verwendung eines an das Sensorsystem anschließbaren dynamischen oder statischen Verstärkungskanals und mit einer an den Verstärkungskanal angeschlossenen akustischen und/oder optischen Signalanzeige, dadurch gekennzeichnet, daß ein dynamisch arbeitender Verstärkungskanal zwischen Sensorsystem und Signalanzeige eingeschaltet ist und ein statisch arbeitender Verstärkungskanal bei Überschreiten des Dynamikbereiches des ersteren selbsttätig eingeschaltet und dieser dann ausgeschaltet wird.

2. Schaltungsanordnung zum Durchführen des Verfahrens nach Anspruch 1 mit einem Sensorsystem, bestehend im wesentlichen aus einer Suchspule, einem Oszillator und einem Gleichrichter, mit einem an das Sensorsystem anschließbaren dynamischen oder statischen Verstärkungskanal und mit einer an den Verstärkungskanal angeschlossenen akustischen und/oder optischen Signalanzeige, dadurch gekennzeichnet, daß ein dynamisch (12) und ein statisch arbeitender Verstärkungskanal (14) vorgesehen sind und beide zwischen Sensorsystem (16, 18, 20) und Signalanzeige liegen und der letztere bei Überschreiten des Dynamikbereiches des ersteren selbsttätig eingeschaltet und dieser dann ausgeschaltet wird.

3. Schaltungsanordnung nach Anspruch 2, dadurch gekennzeichnet, daß am Eingang des statisch arbeitenden Verstärkungskanals (14) ein elektronischer Speicher (34) mit einstellbarer Zeitkonstante liegt.

4. Schaltungsanordnung nach Anspruch 3, dadurch gekennzeichnet, daß der elektronische Speicher (34) ein digitales System ist.

5. Schaltungsanordnung nach einem der Ansprüche 2 bis 4, dadurch gekennzeichnet, daß am Eingang des statisch arbeitenden Verstärkungskanals ein RC-Glied (R₁, R₂, C₁) mit einstellbarem Widerstand liegt.

6. Schaltungsanordnung nach Anspruch 5, gekennzeichnet durch einen parallel zum Widerstand (R₁, R₂) liegenden Taster (36).

7. Schaltungsanordnung nach einem der Ansprüche 2 bis 6, dadurch gekennzeichnet, daß die in den Verstärkungskanälen liegenden Verstärker (26, 38) mit je einem Eingang verschiedener Polarität im Verstärkungsweg liegen und diese über einen einstellbaren Widerstand an eine Bezugsspannung angeschlossen sind.

8. Schaltungsanordnung nach Anspruch 7, dadurch gekennzeichnet, daß der einstellbare Widerstand ein Potentiometer (24) ist, dessen eines Ende an Masse und dessen anderes Ende an der Bezugsspannung liegt und dessen Schleifer mit den Eingängen der beiden Verstärker (26, 38) verbunden ist.

9. Schaltungsanordnung nach Anspruch 7 oder 8, dadurch gekennzeichnet, daß der Eingang des im statischen Verstärkungskanal (14) liegenden Verstärkers (38) über einen einstellbaren Widerstand (42) an das Potentiometer (24) angeschlossen ist.

10. Schaltungsanordnung nach einem der Ansprüche 2 bis 9, dadurch gekennzeichnet, daß zwischen dem Ausgang des dynamischen Verstärkungskanals (12) und der Signalanzeige ein elektronischer Schalter (30) liegt und dieser mit seinem Steuereingang an den Ausgang des statischen Verstärkungskanals (14) derart angeschlossen ist, daß er die Signalanzeige bei Erreichen eines vorgegebenen Spannungspegels am Ausgang des statischen Verstärkungskanals (14) vom dynamischen Verstärkungskanal (12) trennt.

11. Schaltungsanordnung zum Suchen und Orten von Inhomogenitäten in einer nichtmetallischen Umgebung, mit einem Sensorsystem zum Erzeugen eines Signals, bestehend im wesentlichen aus einer Suchspule, einem Oszillator und einem Gleichrichter, mit einem an das Sensorsystem angeschlossenen Verstärkungskanal und mit einer an diesen angeschlossenen akustischen und/oder optischen Signalanzeige, dadurch gekennzeichnet, daß der Verstärker (44) des Verstärkungskanals über ein RC-Glied (R₃, C₂) derart gegengekoppelt ist, daß im Gegenkopplungsweg höherfrequente, schnelle Änderungen des Signals nach Masse abgeleitet werden und damit den Verstärkungskanal ungeschwächt durchlaufen und daß ein einstellbarer Begrenzer (52) zwischen dem RC-Glied und dem Eingang des Verstärkers (44) liegt.

12. Schaltungsanordnung nach Anspruch 11, dadurch gekennzeichnet, daß der Gegenkopplungsweg einen an den Verstärker (44) angeschlossenen Gleichrichter (50) enthält, das RC-Glied an diesen angeschlossen ist, der Kondensator (C₂) mit einem Pol an Masse liegt und das RC-Glied zum Eingang des Verstärkers (44) zurückgeführt ist.

13. Schaltungsanordnung nach einem der Ansprüche 11 oder 12, dadurch gekennzeichnet, daß dem Verstärker (44) ein Tonumsetzer (28) vorgeschaltet und das RC-Glied auf diesen zurückgeführt ist.

14. Schaltungsanordnung nach einem der Ansprüche 11 bis 13, dadurch gekennzeichnet, daß der Widerstand (R₃) des RC-Gliedes einstellbar ist.

## Claims

1. A method of searching for and locating inhomogeneities in a non-metallic environment, with an apparatus having a sensor system for producing a signal, essentially comprising a search coil, an oscillator and a rectifier, using a dynamic or static amplification channel which can be connected to the sensor system, and with an acoustic and/or optical signal display connected to the amplification channel, characterised in that a dynamically operating amplification channel is connected between the sensor system and the signal display and when the dynamic range of the dynamically operating amplification channel is exceeded a statically operating amplification channel is automatically switched on and the dynamically operating amplification channel is then switched off.

2. A circuit arrangement for carrying out the method according to claim 1 with a sensor system essentially comprising a search coil, an oscillator and a rectifier, with a dynamic or static amplification channel which can be connected to the sensor system and with an acoustic and/or optical signal display connected to the amplification channel, characterised in that there are provided a dynamically operating amplification channel (12) and a statically operating amplification channel (14) and the two amplification channels are disposed between the sensor system (16, 18, 20) and the signal display and when the dynamic range of the dynamically operating amplification channel is exceeded the statically operating amplification channel is automatically switched on and the dynamically operating amplification channel is then switched off.

3. A circuit arrangement according to claim 2 characterised in that an electronic memory (34) with adjustable time constant is disposed at the input of the statically operating amplification channel (14).

4. A circuit arrangement according to claim 3 characterised in that the electronic memory (34) is a digital system.

5. A circuit arrangement according to one of claims 2 to 4 characterised in that an RC-member (R₁, R₂, C₁) with adjustable resistor is disposed at the input of the statically operating amplification channel.

6. A circuit arrangement according to claim 5 characterised by a push-button switch (36) disposed parallel to the resistor (R₁, R₂).

7. A circuit arrangement according to one of claims 2 to 6 characterised in that the amplifiers (26, 38) in the amplification channels are disposed with a respective input of different polarity in each amplification path and same are connected to a reference voltage by way of an adjustable resistor.

8. A circuit arrangement according to claim 7 characterised in that the adjustable resistor is a potentiometer (24) of which one end is connected to earth and the other end is connected to the reference voltage and whose slider is connected to the inputs of the two amplifiers (26, 38).

9. A circuit arrangement according to claim 7 or claim 8 characterised in that the input of the amplifier (38) in the static amplification channel (14) is connected to the potentiometer (24) by way of an adjustable resistor (42).

10. A circuit arrangement according to one of claims 2 to 9 characterised in that an electronic switch (30) is disposed between the output of the dynamic amplification channel (12) and the signal display and is connected with its control input to the output of the static amplification channel (14) in such a way that it separates the signal display from the dynamic amplification channel (12) upon the attainment of a predetermined voltage level at the output of the static amplification channel (14).

11. A circuit arrangement for searching for and locating inhomogeneities in a non-metallic environment, having a sensor system for producing a signal, essentially comprising a search coil, an oscillator and a rectifier, having an amplification channel connected to the sensor system, and having an acoustic and/or optical signal display connected to the amplification channel, characterised in that the amplifier (44) of the amplification channel has a negative feedback connection by way of an RC-member (R₃, C₂) in such a way that higher-frequency rapid changes in the signal are diverted to earth in the negative feedback path and thus pass unattenuated through the amplification channel, and that an adjustable limiter (52) is disposed between the RC-member and the input of the amplifier (44).

12. A circuit arrangement according to claim 11 characterised in that the negative feedback path includes a rectifier (50) connected to the amplifier (44), the RC-member is connected to the rectifier, the capacitor (C₂) is connected with one pole to earth and the RC-member is taken back to the input of the amplifier (44).

13. A circuit arrangement according to one of claims 11 and 12 characterised in that an audio converter (28) is connected on the input side of the amplifier (44) and the RC-member is taken back to said converter.

14. A circuit arrangement according to one of claims 11 to 13 characterised in that the resistor (R₃) of the RC-member is adjustable.

## Revendications

1. Procédé pour rechercher et localiser des inhomogénéités dans un environnement non métallique, au moyen d'un appareil comportant un système de capteur pour produire un signal, constitué essentiellement d'une bobine de recherche, d'un oscillateur et d'un redresseur, en utilisant un canal d'amplification dynamique ou statique pouvant être connecté au système de capteur et un affichage de signal acoustique et/ou optique connecté au canal d'amplification, caractérisé en ce qu'un canal d'amplification à fonctionnement dynamique est connecté entre le système de capteur et l'affichage de signal, tandis qu'un canal d'amplification à fonctionnement statique est automatiquement mis en circuit lors du dépassement par excès du domaine dynamique du premier canal, lequel est alors mis hors circuit.

2. Montage de circuit pour l'exécution du procédé suivant la revendication 1, comportant un système de capteur formé essentiellement d'une bobine de recherche, d'un oscillateur et d'un redresseur, un canal d'amplification dynamique ou statique pouvant être connecté au système de capteur et un affichage de signal acoustique et/ou optique connecté au canal d'amplification, caractérisé en ce qu'un canal d'amplification à fonctionnement dynamique (12) et un canal d'amplification à fonctionnement statique (14) sont prévus et sont situés tous deux entre le système de capteur (16, 18, 20) et l'affichage de signal, le dernier étant automatiquement mis en circuit lors du dépassement par excès du domaine dynamique du premier et celui-ci étant alors mis hors circuit.

3. Montage de circuit suivant la revendication 2, caractérisé en ce qu'à l'entrée du canal d'amplification à fonctionnement statique (14) se trouve une mémoire électronique (34) à constante de temps réglable.

4. Montage de circuit suivant la revendication 3, caractérisé en ce que la mémoire électronique (34) est un système numérique.

5. Montage de circuit suivant l'une quelconque des revendications 2 à 4, caractérisé en ce qu'à l'entrée du canal d'amplification à fonctionnement statique est connecté un élément RC (R₁, R₂, C₁) à résistance réglable.

6. Montage de circuit suivant la revendication 5, caractérisé par un bouton-poussoir (36) connecté en parallèle à la résistance (R₁, R₂).

7. Montage de circuit suivant l'une quelconque des revendications 2 à 6, caractérisé en ce que les amplificateurs (26, 38) situés dans les canaux d'amplification sont chacun disposés dans le trajet d'amplification par une entrée de polarité différente, ceux-ci étant connectés par l'intermédiaire d'une résistance réglable à une tension de référence.

8. Montage de circuit suivant la revendication 7, caractérisé en ce que la résistance réglable est un potentiomètre (24), dont l'une des extrémités est mise à la masse, dont l'autre extrémité est connectée à la tension de référence et dont le curseur est connecté aux entrées des deux amplificateurs (26, 38).

9. Montage de circuit suivant la revendication 7 ou 8, caractérisé en ce que l'entrée de l'amplificateur (38) situé dans le canal d'amplification statique (14) est connectée au potentiomètre (24) par l'intermédiaire d'une résistance réglable (42).

10. Montage de circuit suivant l'une quelconque des revendications 2 à 9, caractérisé en ce qu'entre la sortie du canal d'amplification dynamique (12) et l'affichage de signal est disposé un commutateur électronique (30) et ce commutateur est connecté par une entrée de commande à la sortie du canal d'amplification statique (14) d'une manière telle qu'il isole l'affichage de signal du canal d'amplification dynamique (12) lorsqu'un niveau de tension prédéfini est atteint à la sortie du canal d'amplification statique (14).

11. Montage de circuit pour rechercher et localiser des inhomogénéités dans un environnement non métallique, comprenant un système de capteur pour produire un signal, constitué essentiellement d'une bobine de recherche, d'un oscillateur et d'un redresseur, et un canal d'amplification connecté au système de capteur ainsi qu'un affichage de signal acoustique et/ou optique connecté à ce canal, caractérisé en ce que l'amplificateur (44) du canal d'amplification est couplé en retour, par l'intermédiaire d'un élément RC (R₃, C₂), d'une manière telle que, dans le trajet de couplage en retour, des variations rapides à haute fréquence du signal soient dérivées vers la masse et parcourent ainsi le canal d'amplification sans atténuation et qu'un limiteur réglable (52) est situé entre l'élément RC et l'entrée de l'amplificateur (44).

12. Montage de circuit suivant la revendication 11, caractérisé en ce que le trajet de couplage en retour contient un redresseur (50) connecté à l'amplificateur (44), l'élément RC est connecté à ce redresseur, le condensateur (C₂) est mis à la masse par un pôle et l'élément RC est connecté en retour à l'entrée de l'amplificateur (44).

13. Montage de circuit suivant la revendication 11 ou 12, caractérisé en ce qu'un convertisseur de son (28) précède l'amplificateur (44) et l'élément RC est connecté en retour à ce dernier.

14. Montage de circuit suivant l'une quelconque des revendications 11 à 13, caractérisé en ce que la résistance (R₃) de l'élément RC est réglable.
